**Europäisches Patentamt**

**European Patent Office**

**Office européen des brevets**

(19)

(11) Veröffentlichungsnummer: **0 175 351**
**A2**

(12) # EUROPÄISCHE PATENTANMELDUNG

(21) Anmeldenummer: **85111759.8**

(22) Anmeldetag: **17.09.85**

(51) Int. Cl.⁴: **H 01 S 3/23**, H 01 S 3/19

(30) Priorität: **21.09.84 DE 3434741**

(43) Veröffentlichungstag der Anmeldung: **26.03.86**
**Patentblatt 86/13**

(84) Benannte Vertragsstaaten: **DE FR GB**

(71) Anmelder: **Siemens Aktiengesellschaft, Berlin und München Wittelsbacherplatz 2, D-8000 München 2 (DE)**

(72) Erfinder: **Heinen, Jochen, Dr., Dianastrasse 38, D-8013 Haar (DE)**
Erfinder: **Amann, Markus-Christian, Dr., Unterhachinger Strasse 89, D-8000 München 83 (DE)**

(54) **Verkoppelte Laserdioden-Anordnung.**

(57) Anordnung mit übereinanderliegenden laseraktiven Zonen (11, 12) mit epitaktischem Aufbau der Gesamt-Schichtstruktur (2, 31, 32, 41, 42), sodass herstellungsmässig der Abstand der Zonen (11, 12) exacter einzuhalten ist.

EP 0 175 351 A2

0 175 351

Siemens Aktiengesellschaft     Unser Zeichen

Berlin und München             VPA 84 P 1741

$\Lambda$

## Verkoppelte Laserdioden-Anordnung.

Die vorliegende Erfindung bezieht sich auf eine verkoppelte Laserdioden-Anordnung, wie sie im Oberbegriff des Patentanspruchs 1 angegeben ist.

Es ist bekannt, mehrere p-n-Laserdioden mit ihrer jeweiligen streifenförmigen laseraktiven Zone derart benachbart in einem gemeinsamen Halbleiterkörper anzuordnen, daß der (jeweilige) Abstand der streifenförmigen Zonen voneinander so gering ist, daß wellenmechanische Kopplung der Laser-Strahlung in den einzelnen streifenförmigen Zonen eintritt.

Eine derartige wellenmechanische Verkopplung wird z.B. dazu ausgenutzt, Monomoden-Laserstrahlung zu erzeugen. Es läßt sich damit auch Steuerung der Laser-Strahlungserzeugung in der einen Zone durch Intensitätsänderung und/oder Änderung der Anregungsbedingungen der Laserstrahlung in der anderen benachbarten Zone erreichen. Zum Beispiel sind aus Jap. Journ. Appl. Phys., Bd. 17 (1978), Seiten 751 - 752 und aus Journ. Quantum Electr., Bd. QE 13 (1977), S. 619 - 622 Anordnungen bekannt, die übereinanderliegend je eine erste und eine zweite Zone aufweisen. Zwar verläuft in beiden Zonen Laserstrahlung, jedoch erfolgt Strahlungserzeugung durch Stromfluß durch einen p-n-Übergang der Schichtstruktur hindurch allein nur in der ersten Zone. Die andere zweite Zone ist ein passiver optischer Resonator, der wellenmechanisch mit der den p-n-Übergang enthaltenden ersten Zone gekoppelt ist. Der wirksame Bandabstand im Material dieser zweiten Zone, d.h. in der Zone des passiven Resonators, ist größer als derjenige in der ersten Zone mit dem p-n-Übergang. Würde in dieser zweiten Zone Laserstrahlung erzeugt werden, würde deren Frequenz verschieden von, nämlich

Bts 1 Kow / 11.6.1985

-1a-

höher als die Frequenz derjenigen Laserstrahlung sein, die in
dieser bekannten Anordnung nämlich in deren erster Zone mit
p-n-Übergang tatsächlich erzeugt wird. Damit wäre aber die
vorgesehene wellenmechanische Kopplung unmöglich, d.h. die
passive Eigenschaft dieser zweiten Zone ist von entscheidender Bedeutung für diesen Stand der Technik.

Es sind auch Array-Anordnungen mit miteinander gekoppelten,
Laserstrahlung erzeugenden Streifen, d.h. mit miteinander
gekoppelten Laserdioden bekannt, ausgeführt in bzw. auf einem
Halbleiterkörper. Hinsichtlich weiterer Einzelheiten zu
derartigen bekannten Anordnungen sei verwiesen auf "Appl.
Physics Letters", Bd. 42 (1983), SEiten 152 - 154 und Bd.43
(1983), Seiten 521-523; "4. Intern. Conference on Integrated
Optics and Optical Fibre Communication", 27.-30. Juni 1983,
Tokyo; "IEEE Journ. of Quantum Electonics", Bd.QE 18 (1982),
Seiten 1679-1688; "Appl. Physics Letters", Bd.41 (1982),
Seiten 112-114; US-PS 4 347 612, US-PS 4 277 762 und US-PS 4
101 845.  Weiterer technologischer Hintergrund zur vorliegenden Erfindung ist in "IEEE Spectrum" (1983), Seiten
38-45 angegeben.

Bekannt ist aus voranstehenden Druckschriften die longitudinale Hintereinanderstellung und die laterale Nebeneinanderstellung jeweiliger laseraktiver Zonen bzw. Laserdioden-
Streifen in einer Anordnung auf bzw. in einem Substratkörper. Wesentliches Problem für die Herstellung einer solchen
Anordnung ist die Justierung dieser Zonen bzw. Laser zueinander, da schon geringe Abstandsabweichungen erhebliche Einflüsse haben. Bei indexgeführten Laserdioden kommt noch hinzu, daß aufgrund der geringen Breite des wellenmechanischen
bzw. wellenoptischen Nahfeldes der Laserstrahlung die in Frage
kommenden Abstandsabmessungen sehr klein sind. Bei den Laserdioden handelt es sich in der Regel um solche des Doppelheterostrukturtyps aus beispielsweise Indium-Gallium-Arsenid-Phosphid/Indiumphosphid. Insbesondere bei Laserdioden dieser Art
können zwei miteinander zu koppelnde Laserdioden auch bei Ausführung als indexgeführte Laserdioden in geringem Abstand voneinander angeordnet werden.

Aufgabe der vorliegenden Erfindung ist es, eine Anordnung und
ein Herstellungsverfahren für diese Anordnung anzugeben, bei
der verringerter technologischer Aufwand und/oder erhöhte
Sicherheit für die Einhaltung vorgegebener Abstände erreicht
ist.

Diese Aufgabe wird mit den Maßnahmen des Patentanspruchs 1 gelöst. Weitere Ausgestaltungen und Weiterbildungen der Erfindung gehen aus den Unteransprüchen hervor.

Das Prinzip der erfindungsgemäßen Lösung ist, zwei oder mehrere streifenförmige laseraktive Zone benachbart zueinander in
Übereinanderstellung im gesamten Halbleiterkörper anzuordnen.
Ohnehin werden die Halbleiterkörper der Laserdioden und insbesondere solcher mit Doppelheterostruktur durch mehrfaches epitaktisches Abscheiden verschiedener Schichten übereinander hergestellt. Für eine Doppelheterostruktur werden im Regelfall drei Schichten und ein Substratkörper benötigt, wobei der Substratkörper auch die Funktion einer der Schichten übernehmen kann. Die laseraktive Zone befindet sich wenigstens weitgehend im Bereich der jeweils mittleren Schicht (bei 3-Schichtanordnung), wobei die ganz genaue Lage von bekannten technologischen Feinheiten wie Dotierungsgrad und gegebenenfalls -gradient und/oder Wahl der Materialien der Schichtfolge u.dergl. abhängt.

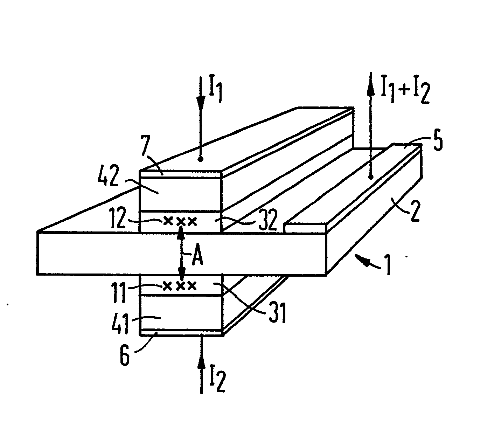

Weitere Erläuterungen der Erfindung gehen aus der nachfolgenden, anhand der Figur gegebenen Beschreibung hervor.

Mit 1 ist die gesamte aus bei diesem Beispiel zwei gekoppelten streifenförmigen laseraktiven Zonen bestehende Anordnung mit zwei gekoppelten Laserdioden bezeichnet. In der Darstellung der Figur ist oberhalb und unterhalb des als Substratkörper dienenden Anteils 2 aus beispielsweise In P........ je eine der miteinander verkoppelten Laserdioden angeordnet. Der Substratkörper ist die Mittelschicht 2 und auch erste Schicht der jeweiligen Doppelheterostruktur der einzelnen Dioden, zu denen jeweils die Schichten 31 und 32 sowie 41 und 42 gehören. Es liegen somit zwie Symmetrieanteile vor. Wie dargestellt, sind diese Schichten 31, 32, 41, 42 übereinanderliegend epitaktisch aufeinander bzw. auf der Mittelschicht 2 abgeschieden. Im Regelfall wird die in der Figur dargestellte Form durch nachfolgenden Ätzprozeß hergestellt sein, da derartige Formgabe im Verlauf epitaktischer Abscheidung zwar möglich, aber aufwendig ist. Die Schichten 31, 2 bestehen beispielsweise aus In GaAs P und die Schichten 41 und 42 aus beispielsweise In P.

Mit 5 ist der elektrische Substratanschluß, eine z.B. streifenförmige Kontaktelektrode, bezeichnet. Weitere streifenförmige bzw. flächenförmige Eklektroden sind mit 6 und 7 bezeichnet. Der zur Laser-Anregung dienende elektrische Strom
$I_1$, $I_2$ fließt beispielsweise wie in der Figur angegeben. Mit
11 und 12 sind die stirnseitigen Querschnittsflächen der jeweiligen streifenförmigen laseraktiven Zone bezeichnet. Auf
ihren Abstand voneinander ist mit dem Pfeil A hingewiesen.

Wie ersichtlich, ist das Substrat 2 ein wesentlicher Anteil
des zwischen den Zonen 11 und 12 befindlichen Halbleitermaterials, über das hinweg die wellenoptische Kopplung erfolgt.
Die Dicke dieser Mittelschicht 2 , für die Abmessungen von
etwa 0,1 bis 0,3 µm einzuhalten sind, bestimmt im wesentlichen den Abstand A. Im epitaktischen Herstellungsverfahren
läßt sich aber die Dicke einer Schicht sehr exakt einstellen
bzw. einhalten. Die Erfindung bietet auch für Massenfertigung
die Gewähr geringer Exemplarstreuung und geringen Ausschusses.
Auch liegt bei der Erfindung der Vorteil vor, daß (spätere)
äußere Einflüsse, die auf die Anordnung 1 einwirken, auf die
abstandsabhängige wellenoptische Kopplung der Zonen 11 und 12
nicht einwirken können. Der Kopplungsbereich ist hermetisch
gegenüber dem Äußeren abgeschlossen.

Hergestellt wird eine erfindungsgemäße Anordnung 1, indem man
die aus der Figur zu entnehmende Schichtfolge übereinander
epitaktisch abscheidet und vorteilhafterweise die bei der Abscheidung zunächst seitlich der Schichten 41, 31, 32 und 42
entstehenden Halbleiteranteile nachträglich wegätzt. Dies
erfolgt mit üblicherweise angewendetem Maskenätzen, Ionenstrahlätzen und dergleichen.

-5-

Patentansprüche

Verkoppelte Laserdiodenanordnung zwei jeweils in
Schichtstrukturaufbau ausgeführten Laser-Dioden, wobei
die zwei streifenförmigen laseraktiven Zonen in definiertem
Abstand zueinander angeordnet sind,
g e k e n n z e i c h n e t   d a d u r c h ,
daß die beiden Schichtstrukturen (231, 41 und 232, 42)
symmetrisch zur Mittelschicht (2) aufgebaut sind,
so daß die beiden laseraktiven Zonen (11,12)  in diesem
Aufbau im jeweiligen Symmetrieanteil (31, 41/ 32, 42) bezogen auf die Mittelschicht (2) übereinanderliegend angeordnet sind und
daß diese Mittelschicht eine epitaktisch abgeschiedene, in
ihrer Dicke exact bemessene Schicht ist.

2. Anordnung nach Anspruch 1,
g e k e n n z e i c h n e t   d a d u r c h ,
daß die einzelnen Laserdioden (2, 31, 41; 2, 32, 42)
indexgeführte Laser sind.

3. Anordnung nach Anspruch 1 oder 2,
g e k e n n z e i c h n e t   d a d u r c h ,
daß die Dicke der Mittelschicht (2) zwischen 0,1 und 0,3µm
bemessen ist.